# EUROPEAN PATENT APPLICATION

(11) **EP 1 267 459 A1**
(43) Date of publication of application: **18.12.2002**
(21) Application number: 01305250.1
(22) Date of filing: 15.06.2001
(51) Int. Cl.: H01S 5/022

(54) **Heatsinks for laser electronic packages**

(71) Applicant: Agilent Technologies, Inc. (a Delaware corporation), Palo Alto, CA 94303 (US)
(72) Inventor: Healy, David, Ipswich, Suffolk IP5 3SA (GB)
(74) Representative: Coker, David Graeme

(57) **Abstract**

An electronic package (200) includes a metal housing (201) and a laser diode (202) and a photo diode (230) contained within the metal housing (201). One or more leads (206, 208, 210, 212,) pass into the metal housing through a header (204) and are coupled to the laser diode (202) and the photo diode (230). The laser diode (202) and the photo diode (230) are mounted on a first face (226) of a heatsink (234) such that they are substantially coplanar. A metallisation pattern (232) is applied to the first face (226) of the heatsink (234) and extends to a second face (236), which is substantially orthogonal to the first face (226). The metallisation pattern (232) on the second face (236) extends close to the appropriate leads so that wire bonds (238) can easily be made from the leads to the metallisation pattern (232) on the second face (236) of the heatsink (234).

## Description

### Field of the Invention

This invention relates, in general, to laser electronic packages and more particularly to heatsinks for laser electronic packages having optical devices, such laser diodes, mounted therein.

### Background of the Invention

Laser diodes, are often housed within so called "Transistor Outline (TO)-Cans", which are metallic, generally cylindrically shaped housings in which the laser diode is mounted on a heatsink and coupled appropriately to leads supplying data signals, as well as power. The heatsink is usually mounted on a header, such as a CD header, which acts as a "lid" for the can housing. An example of this is a TO-Can housing containing a laser diode mounted on a heat sink, with data and power leads leading to the laser diode entering the housing via insulating seals in the header. A photodiode is mounted such that it is positioned below the laser diode to measure the amount of back light emitted by the laser diode. This measurement gives an indication of the forward light emitting power of the laser and can be used in a feedback loop to control the laser diode. Wire bonds extend from the laser diode and the photo diode to appropriate ones of the leads. The positions of the laser diode and the photo diode are usually such that the wire bonding apparatus must be able to bond at a number of different levels and to surfaces at different angles.

Therefore, it is an object of the present invention to provide a heatsink for a laser electronic packages which overcomes, or at least reduces the disadvantages of the known devices described above.

### Brief Summary of the Invention

Accordingly, in a first aspect, the present invention provides a heatsink for a laser diode, the heatsink comprising a heat conducting substrate having a first face and a second face adjacent the first face, the first face having a first planar portion to which a laser diode can be mounted and a second planar portion to which a photo diode can be mounted, and an electrically conductive metallisation pattern having at least first and second pairs of metallic paths applied to at least part of the first face of the substrate and extending to at least part of the second face of the substrate, whereby, in use, electrical connections can be made between the laser diode and the first pair of metallic paths on the first face of the substrate, the photo diode and the second pair of metallic paths on the first face of the substrate and between the first and second pairs of metallic paths on the second face of the substrate and respective power supply pins.

According to a second aspect of the present invention, there is provided an optical transceiver package comprising a header having at least a pair of power supply pins extending therethrough, a heatsink mounted on the header, the heatsink comprising a heat conducting substrate having a first face and a second face adjacent the first face, the first face having a first planar portion and a second planar portion and an electrically conductive metallisation pattern having at least first and second pairs of metallic paths applied to at least part of the first face of the substrate and extending to at least part of the second face of the substrate, a laser diode mounted to the first planar portion of the substrate and electrically coupled to the first pair of metallic paths on the first face of the substrate, a photo diode mounted to the second planar portion of the substrate and electrically coupled to the second pair of metallic paths on the first face of the substrate, electrical connections coupled between the pair of power supply pins and the first and second pairs of metallic paths on the second face of the substrate, and a can mounted to the header to enclose the heatsink, laser diode, photo diode and electrical connections.

### Brief Description of the Drawings

One embodiment of the present invention will now be described, by way of example, with reference to the accompanying drawings, of which:
FIG. 1 is an illustration of a known laser diode TO-Can package; and
FIG. 2 is an illustration of a laser diode TO-Can package according to one embodiment of the present invention.

### Detailed Description of the Drawings

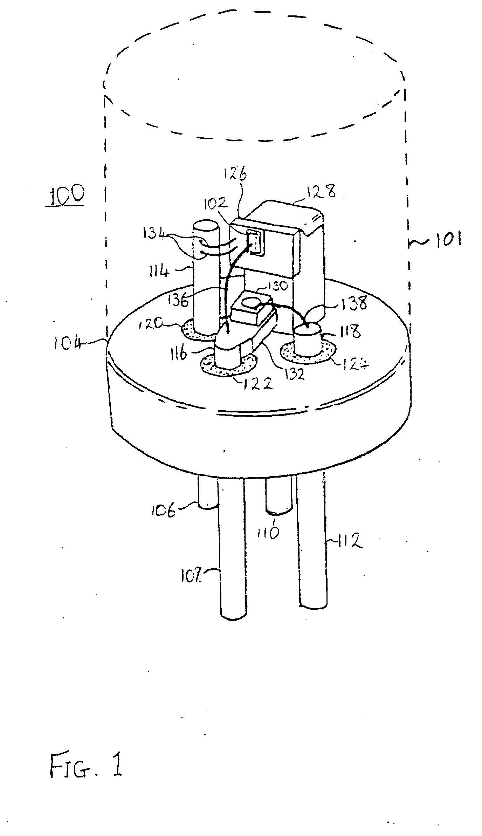

Thus, FIG. 1 shows a known electronic package 100 having a laser diode 102 mounted in a TO-Can housing 101, with further components (not shown) being housed in other parts of the housing 101. The To-Can housing 101 is generally cylindrical and incorporates a TO-Can header 104 having four pins 106, 108, 110, 112 passing through the central part of the header 104 to an internal portion of the TO-Can housing 101 for connection to the electrical components therewithin. Each of the four pins 106, 108, 110, 112 is held in position by a glass seal 120, 122, 124 (the glass seal for laser heat sink pin 110 is not illustrated) surrounding each pin where it passes through the TO-Can header 104. A cathode pin 106 terminates in the form of a cathode 114 on an internal side of the TO-Can header 104, an anode pin 108 terminates in the form of an anode 116 on the internal side of the TO-Can header 104, and a photodiode pin 112 terminates in the form of a photodiode terminal 118 on the internal side of the TO-Can header 104. A laser heat sink pin 110 terminates in the form of a laser heatsink block 128 on the internal side of the TO-Can header 104.

The laser heatsink block 128 has a metal laser heatsink 126 attached to a surface thereof and a laser diode 102 is located on a surface of the laser heatsink 126. The anode 116 of anode pin 108 terminates in a metal tab 132, which extends below the metal laser heatsink 126 and has a photodiode 130 positioned thereon. A pair of bond wires 134 couple the laser heatsink 126 to the cathode 114, a bond wire 136 couples the laser diode 102 to the anode 116, and a further bond wire 138 couples the photodiode 130 to the photodiode terminal 118.

In operation, a high frequency input signal is applied to the cathode 114. A supply voltage is applied to the anode 116 and the anode 116 also functions as a bias for the photodiode 130. The photodiode 130, whilst not essential to the operation of the laser diode, functions to register the amount of light emitted from the laser diode 102. By means of a feedback loop, the photodiode 130 controls the light intensity emitted by the laser diode 102. The laser heatsink pin 110 is generally coupled to signal ground which acts to ground the TO-Can metal body. As can be seen, the wire bonds 134, 136 and 138 are formed at surfaces which are both horizontal and vertical, at different levels and, in one case, curved. Therefore, the wire bonding apparatus must be relatively sophisticated in order to be able to be programmable to carry out the wire bonding.

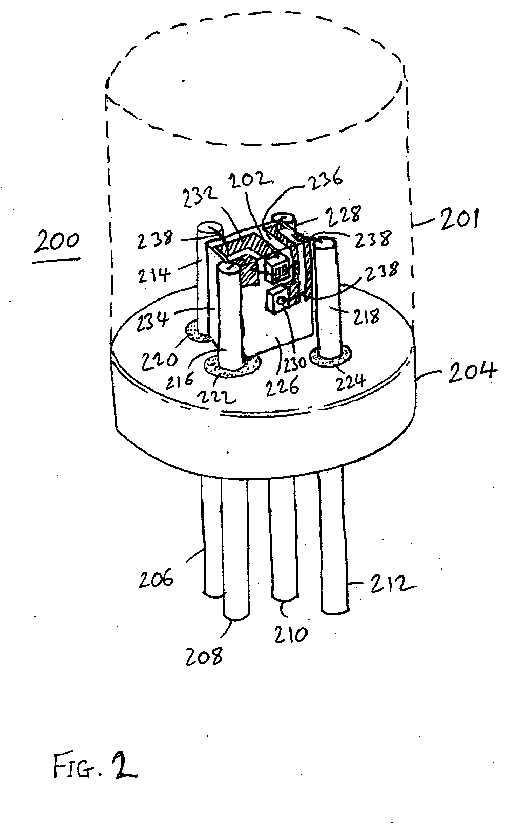

FIG. 2 shows an electronic package 200 formed of a TO-Can housing 201 (shown in outline) and a TO-Can header (sometimes known as a CD header). The electronic package 200 houses a laser diode 202, a photo diode 230 and, possibly, further components (not shown). The TO-Can housing is hermetically sealed to the CD header and is provided with a window or lens at its end remote from the CD header to let light from the laser diode out.

Four pins 206, 208, 210 and 212 pass through a central part of the header 204 to an internal portion of the TO-Can housing 201 for connection to the electrical components therewithin. As before, each of the four pins 206, 208, 210 and 212 is held in position by a glass seal 220, 222, 224 (the glass seal for pin 210 is not illustrated) surrounding each pin where it passes through the TO-Can header 204. The pins constitute a cathode pin 208, an anode pin 210, a photodiode pin 212 and a laser heat sink pin 206.

The laser diode 202 and the photo diode 230 are both mounted on a first, in this case vertical, face of a heatsink 234, which is positioned on the CD header 204 between the four pins. The heatsink 234 is preferably made of Aluminium Nitride or Silicon Nitride or a similar material that electrically isolates the laser diode from the pins and the CD header, which is often made of a conductive material such as mild steel. The laser diode 202 and the photo diode 230 are mounted on portions of the first face 226 of the heatsink 234 that are substantially coplanar, so that the photo diode 230 is as close as possible to the back facet of the laser diode 202 to collect as much of the back-reflected light therefrom as possible.

The heatsink 234 is provided with an electrically conductive metallisation pattern 232 on at least the first face 226 and on a second face 236 which is substantially orthogonal to the first face 226, and, in this case, is substantially horizontal. The metallisation pattern 232 thus extends over the edge between the first and second faces and provides an electrically conductive connection between respective metal lines on the first face and respective metal lines on the second face 236 of the heatsink 234. The metallisation pattern 232 is applied to the heatsink 234 be means of standard photolithographic techniques, involving depositing one or more metal layers and photoresist layers and appropriately etching them to obtain the desired pattern. Since these techniques are weel known, no further description of them will be made.

Electrical connections, such as wire bonds 238, are made between the laser diode 203 and the photo diode 230 and appropriate ones of the metal lines on the first face of the heatsink 234. In some cases, the electrical connections between the laser diode and the photo diode and the metal lines are made by directly contacting the diode onto a metal line provided on the heatsink 234. Similarly, electrical connections, such as wire bonds 238, are made between appropriate ones of the metal lines on the second face of the heatsink 234 and the four pins 206, 208, 210 and 212.

Thus, a first connection is made from the back of the laser diode 202 to a metal line on the first face of the heatsink, which metal line extends to the second face of the heatsink adjacent pin 206 and a wire bond connection is made from the metal line to a terminal 214 forming the end of the heat sink pin 206. A second connection is made from a first electrode on the front of the laser diode 202 to a metal line on the first face of the heatsink, which metal line extends to the second face of the heatsink adjacent cathode pin 208 and a wire bond connection is made from the metal line to a cathode terminal 216 forming the end of the cathode pin 208. A third connection is made from a second electrode on the front of the laser diode 202 to a metal line on the first face of the heatsink, which metal line extends to the second face of the heatsink adjacent anode pin 210 and a wire bond connection is made from the metal line to an anode terminal 228 forming the end of the anode pin 210. The metal line to which the second electrode of the laser diode is connected, further extends to the photo diode 230 and is contacted by the back face of the photo diode 230 so that a connection is also made form the anode terminal 228 to the photo diode 230. Finally, a connection is made from an electrode on the front of the photo diode 202 to a metal line on the first face of the heatsink 234, which metal line extends to the second face of the heatsink 234 adjacent photo diode pin 212 and a wire bond connection is made from the metal line to a terminal 218 forming the end of the photo diode pin 212.

The operation of the electronic package 200 is substantially the same as that of the electronic package 100 described above with reference to FIG. 1 and will not be further described here. However, it will be appreciated that the configuration of electronic package 200, and in particular the provision of a metallisation pattern on the heatsink 234 means that simple short wirebonds can be used from the pin terminals to the metal strips of the metallisation pattern. The metallisation pattern can be folded around the faces of the heatsink such that the wirebonds can be positioned in a different plane to that in which the components, such as the laser diode and the photo diode, have been placed. Thus, all the wirebonding can be carried out in the same plane, leading to simplicity, ease and cheapness of the wirebonding process, since complicated swivel wirebonds are not needed.

An advantage of the configuration described above with reference to FIG. 2 is that the heatsink assembly having the laser diode and the photo diode can be assembled separately and then mounted on the header. This means that the alignment of the laser diode and the photo diode, part from being more accurate due to the coplanarity of the face on which they are mounted, can be more easily monitored and tested on the assembly line. Furthermore, larger heatsinks are possible than hitherto, with a reduction in size of the CD header allowing a reduction in size of the whole TO-can package, because all the wire bonds can now be in the same plane above the terminals of the pins, allowing the heatsink to be positioned closer to the poins than hitherto. Since the wirebonds are shorter, this also reduces their electrical effects, such as inductance and also provides greater mechanical stability.

Changes in the configuration, such as changes in the electrical functionality of the pins, for example due to changes in the origin of the components, can also easily be achieved by simply changing the metallisation pattern, without needing to change other, more costly parts of the manufacturing process. As mentioned above, other components, such as , for example, anintegrated high speed switch and laser driver, can also easily be mounted on the heatsink and appropriate connections made thereto by changing the metallisation pattern appropriately.

It will also be appreciated that the electrical connections between the pin terminals and the metal strips of the metallisation pattern, need not be wire bonds, as described above, but could be, for example, tape bonds. These are strips of metal formed on a tape and used as electrical connectors. Again, the configuration described above, facilitates the use of such tape bonds, since the bonds are shorter than hitherto and, because they are all in the same plane, the tape does not need to be twisted and bent to the same degree as was necessary in previous configurations.

Whilst only one particular embodiment of the invention has been described above, it will be appreciated that a person skilled in the art can make modifications and improvements without departing from the scope of the present invention. For example, although the metallisation pattern has been described above as being applied by photolithographic techniques, it will be appreciated that any suitable techniques may be used and the invention is not limited to photolithographic techniques.

## Claims

1. A heatsink (234) for a laser diode (202), the heatsink (234) comprising a heat conducting substrate having a first face (226) and a second face (236) adjacent the first face, the first face having a first planar portion to which a laser diode (202) can be mounted and a second planar portion to which a photo diode (230) can be mounted, and an electrically conductive metallisation pattern (232) having at least first and second pairs of metallic paths applied to at least part of the first face of the substrate and extending to at least part of the second face (236) of the substrate, whereby, in use, electrical connections can be made between the laser diode (202) and the first pair of metallic paths on the first face (226) of the substrate, the photo diode (230) and the second pair of metallic paths on the first face (226) of the substrate and between the first and second pairs of metallic paths on the second face (236) of the substrate and respective power supply pins.

2. A heatsink according to claim 1, wherein the second face is substantially orthogonal to the first face.

3. A heatsink according to either claim 1 or claim 2, wherein said electrically conductive metallisation pattern is produced using photolithographic techniques.

4. A heatsink according to any one of claims 1, 2 or 3, wherein said electrically conductive metallisation pattern is produced by painting with electrically conductive paint over an edge of the substrate between the first and second faces.

5. A heatsink according to any one of claims 1 to 4, wherein said electrical connections are wire bonds.

6. A heatsink according to any one of claims 1 to 4, wherein said electrical connections are tape bonds.

7. A heatsink according to any one of claims 1 to 5, wherein said first and second planar portions are substantially co-planar.

8. An optical transceiver package (200) incorporating a heatsink according to any one of claims 1 to 7.

9. An optical transceiver package (200) comprising a header (204) having at least a pair of power supply pins (206, 208, 210, 212) extending therethrough, a heatsink (234) mounted on the header (204), the heatsink (234) comprising a heat conducting substrate having a first face (226) and a second face (236) adjacent the first face (226), the first face (226) having a first planar portion and a second planar portion and an electrically conductive metallisation pattern (232) having at least first and second pairs of metallic paths applied to at least part of the first face (226) of the substrate and extending to at least part of the second face (236) of the substrate, a laser diode (202) mounted to the first planar portion of the substrate and electrically coupled to the first pair of metallic paths on the first face of the substrate, a photo diode (230) mounted to the second planar portion of the substrate and electrically coupled to the second pair of metallic paths on the first face (226) of the substrate, electrical connections (238) coupled between the pair of power supply pins (206, 208, 210, 212) and the first and second pairs of metallic paths on the second face (236) of the substrate, and a can (201) mounted to the header (204) to enclose the heatsink (234), laser diode (202), photo diode (232) and electrical connections (238).

10. An optical transceiver package according to claim 9, wherein the second face is substantially orthogonal to the first face.

11. An optical transceiver package according to either claim 9 or claim 10, wherein said electrically conductive metallisation pattern is produced using photolithographic techniques.

12. An optical transceiver package according to any one of claims 9, 10 or 11, wherein said electrically conductive metallisation pattern is produced by painting with electrically conductive paint over an edge of the substrate between the first and second faces.

13. An optical transceiver package according to any one of claims 9 to 12, further comprising at least one further electronic component mounted to the heatsink and wherein the electrically conductive metallisation pattern is adapted to make electrical connection thereto.

14. An optical transceiver package according to any one of claims 9 to 13, wherein the first and second pairs of metallic paths on the second face of the substrate are arranged to extend to a close proximity to the respective power supply pins to which they are electrically connected.

15. An optical transceiver package according to any one of claims 9 to 14, wherein said electrical connections comprise wire bonds.

16. An optical transceiver package according to any one of claims 9 to 14, wherein said electrical connections comprise tape bonds.

17. An optical transceiver package according to any one of claims 9 to 16, wherein said first and second planar portions are substantially co-planar.
